# EUROPEAN PATENT APPLICATION

(11) **EP 1 764 839 A2**
(43) Date of publication of application: **21.03.2007**
(21) Application number: 06254782.3
(22) Date of filing: 14.09.2006
(51) Int. Cl.: H01L 29/786

(54) **Transparent thin film transistor (TFT) and its method of manufacture**

(30) Priority: 14.09.2005 KR 20050085897
(71) Applicant: Samsung SDI Co., Ltd., Suwon-si, Gyeonggi-do (KR)
(72) Inventor: Jeong, Jae Kyeong, Kiheung-eup Yongin-si Gyeonggi-do (KR); Shin, Hyun Soo, Kiheung-eup Yongin-si Gyeonggi-do (KR); Mo, Yeon Gon, Kiheung-eup Yongin-si Gyeonggi-do (KR)
(74) Representative: Mounteney, Simon James

(57) **Abstract**

A transparent thin film transistor (TFT) and its method of manufacture includes: a substrate, a transparent semiconductor layer formed by coating the substrate with an oxide, a nitride, or a carbide to pattern the material, a gate insulating layer formed on the transparent semiconductor layer, a gate electrode formed on the gate insulating layer to correspond to the transparent semiconductor layer, an interlayer insulating layer formed on the gate electrode, and source and drain electrodes electrically connected to the transparent semiconductor layer through contact holes formed in the interlayer insulating layer and the gate insulating layer.

## Description

The present invention relates to a transparent Thin Film Transistor (TFT) and its method of manufacture, and more particularly, to a transparent TFT in which a semiconductor layer is formed of a transparent material to improve its aperture ratio so that it is possible to relax design rules of a display and to improve the resolution of the display.

Recently, a Thin Film Transistors (TFTs) have been widely used as switching devices to control pixels in display devices such as an Organic Light Emitting Displays (OLEDs) and Liquid Crystal Displays (LCDs). Therefore, significant attention is being paid to the manufacture of TFTs and more effective TFTs and methods of their manufacture are being provided.

In general, in the TFT, a semiconductor layer is formed on a substrate in a predetermined pattern. A gate insulating layer is formed on the semiconductor layer and a gate electrode is patterned on the gate insulating layer in a predetermined shape. An interlayer insulating layer is formed on the gate electrode and source and drain electrodes are formed on the interlayer insulating layer to be electrically connected to both sides of the semiconductor layer through contact holes.

The semiconductor layer of the TFT is commonly formed of amorphous silicon and a channel region through which carriers such as holes and electrons can move is formed in the semiconductor layer.

However, when the TFT is used as the switching device of the light emitting display, there are limitations on increasing the width of the channel since the amorphous silicon is opaque. Therefore, a large current cannot flow on the semiconductor layer so that a high voltage is supplied to the TFT. However, when a high voltage is supplied to the TFT, the TFT deteriorates and power consumption increases.

Also, when the TFT is used for an LCD, the semiconductor layer has photoconductivity in a visible ray region, that is, reacts to light when light is radiated so that carriers are generated in the semiconductor layer. According to such a phenomenon, light is radiated even though the TFT is being controlled to be turned off so that carriers are generated in the semiconductor layer. Therefore, resistance is reduced so that power consumption increases.

Accordingly, it is an object of the present invention to provide a transparent Thin Film Transistor (TFT) in which a semiconductor layer is formed of a transparent material to improve its aperture ratio so that it is possible to relax design rules of a display and to improve resolution of the display and a method of manufacturing the transparent TFT.

In order to achieve the foregoing and/or other objects of the present invention, according to one aspect of the present invention there is provided a transparent thin film transistor as set out in claim 1. Preferred features are set out in claims 2 to 8.

A transparent Thin Film Transistor (TFT) may include: a substrate; a transparent semiconductor layer arranged on the substrate, the transparent semiconductor layer including one of an oxide, a nitride, or a carbide patterned on the substrate; a gate insulating layer arranged on the transparent semiconductor layer; a gate electrode arranged on the gate insulating layer to correspond to the transparent semiconductor layer; an interlayer insulating layer arranged on the gate electrode; and source and drain electrodes electrically connected to the transparent semiconductor layer through contact holes arranged in the interlayer insulating layer and the gate insulating layer.

The transparent semiconductor layer preferably includes a wide band gap semiconductor material having a band gap greater than 3.0eV. The transparent semiconductor layer preferably includes a semiconductor material selected from a group consisting of ZnO, ZnSnO, CdSnO, GaSnO, TlSnO, InGaZnO, CuAlO, SrCuO, and LaCuOS. The transparent semiconductor layer alternatively preferably includes a semiconductor material selected from a group consisting of GaN, InGaN, AlGaN, and InGaAlN. The transparent semiconductor layer alternatively preferably includes a semiconductor material selected from a group consisting of SiC and diamond. The semiconductor layer preferably has a thickness in a range of 300Å to 700Å.

The transparent Thin Film Transistor (TFT) may include: a substrate; a gate electrode arranged on the substrate; a gate insulating layer arranged on the gate electrode and the substrate; a transparent semiconductor layer arranged on the gate insulating layer, the transparent semiconductor layer including one of an oxide, a nitride, or a carbide patterned on the gate insulating layer; and source and drain electrodes arranged on the transparent semiconductor layer to expose a region of the transparent semiconductor layer.

The transparent semiconductor layer preferably includes a wide band gap semiconductor material having a band gap greater than 3.0eV. The transparent semiconductor layer preferably includes a semiconductor material selected from a group consisting of ZnO, ZnSnO, CdSnO, GaSnO, T1SnO, InGaZnO, CuAlO, SrCuO, and LaCuOS. The transparent semiconductor layer alternatively preferably includes a semiconductor material selected from a group consisting of GaN, InGaN, AlGaN, and InGaAlN. The transparent semiconductor layer alternatively preferably includes a semiconductor material selected from a group consisting of SiC and diamond. The transparent semiconductor layer preferably has a thickness in a range of 300Å to 700Å.

In order to achieve the foregoing and/or other objects of the present invention, according to another aspect of the present invention, a method of manufacturing a transparent Thin Film Transistor (TFT) is provided as set out in claim 9. Preferred features are set out in claims 10 to 13.

The method including: coating a substrate with an oxide, a nitride, or a carbide to form a transparent semiconductor layer; forming a gate insulating layer on the transparent semiconductor layer; forming a gate electrode on the gate insulating layer to correspond to the transparent semiconductor layer; forming an interlayer insulating layer on the gate electrode; and forming contact holes that pass through the interlayer insulating layer and the gate insulating layer and depositing a transparent electrode to form source and drain electrodes.

Forming the transparent semiconductor layer preferably includes one of: a Pulse Laser Deposition (PLD) method, an Atomic Layer Deposition (ALD) method, a Chemical Vapor Deposition (CVD) method, a sputtering method, and a Molecular Beam Epitaxy (MBE) method.

The method may include: forming a gate electrode patterned on a substrate; forming a gate insulating layer on the gate electrode; coating the gate insulating layer with an oxide, a nitride, or a carbide to form a transparent semiconductor layer; and forming source and drain electrodes on the transparent semiconductor layer.

Forming the transparent semiconductor layer preferably includes one of: a Pulse Laser Deposition (PLD) method, an Atomic Layer Deposition (ALD) method, a Chemical Vapor Deposition (CVD) method, a sputtering method, and a Molecular Beam Epitaxy (MBE) method.

A more complete appreciation of the present invention and many of the attendant advantages thereof will be readily apparent as the present invention becomes better understood by reference to the following detailed description when considered in conjunction with the accompanying drawings in which like reference symbols indicate the same or similar components, wherein:

FIG. 1 is a schematic sectional view of a transparent Thin Film Transistor (TFT) having a top gate structure according to a first embodiment of the present invention;

FIGs. 2A to 2C are sectional views of processes of a method of manufacturing the TFT according to the first embodiment of the present invention;

FIG. 3 is a schematic sectional view of a transparent TFT having a bottom gate structure according to a second embodiment of the present invention; and

FIGs. 4A and 4B are sectional views of processes of a method of manufacturing the TFT according to the second embodiment of the present invention.

Hereinafter, exemplary embodiments of the present invention are described in detail with reference to the attached drawings.

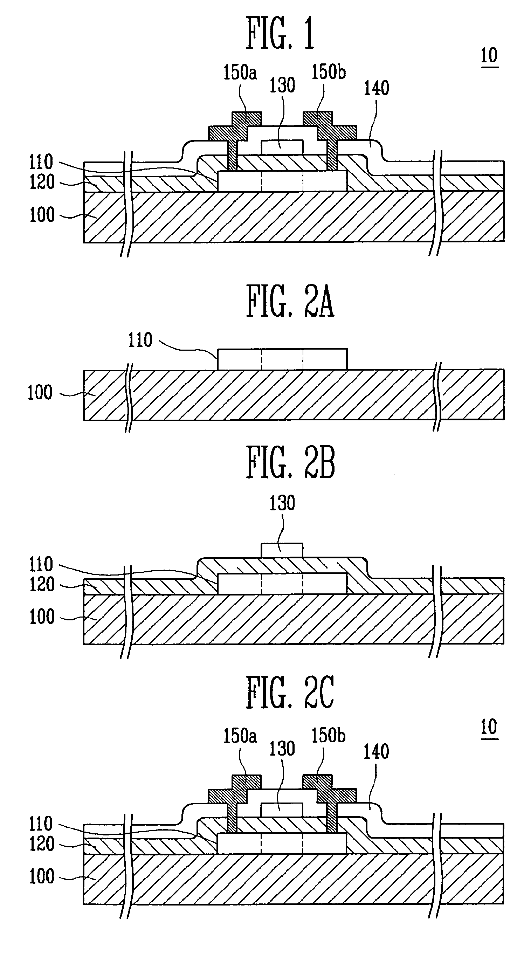

FIG. 1 is a schematic sectional view of a Transparent Thin Film Transistor (TFT) having a top gate structure according to a first embodiment of the present invention.

Referring to FIG. 1, a transparent TFT 10 according to the first embodiment of the present invention includes a semiconductor layer 110 formed by coating a substrate 100 with a wide band gap semiconductor material whose band gap is no less than 3.0eV to pattern the semiconductor material into a predetermined shape, an insulating layer 120 formed on the semiconductor layer 110, a gate electrode 130 formed on the gate insulating layer 120 to be patterned to correspond to the transparent semiconductor layer 110, an interlayer insulating layer 140 formed on the gate electrode 130, and source and drain electrodes 150a and 150b electrically connected to the transparent semiconductor layer 110 through contact holes (not shown) formed in the gate insulating layer 120 and the interlayer insulating layer 140.

The substrate 100 is formed of an insulating material, such as glass, plastic, silicon, or a synthetic resin, and is preferably a transparent substrate, such as a glass substrate.

The transparent semiconductor layer 110 is formed on the substrate 100 in a predetermined pattern. The transparent semiconductor layer 110 is formed of at least one conductive metal material selected from the group consisting of ZnO, ZnSnO, CdSnO, GaSnO, TlSnO, InGaZnO, CuAlO, SrCuO, and LaCuOS, which are wide band gap semiconductor material oxides whose band gap is no less than 3.0eV, the group consisting of GaN, InGaN, AlGaN, and InGaAlN, which are nitrides, or the group consisting of SiC and diamond, which are carbides.

The gate insulating layer 120 is formed on the transparent semiconductor layer 110 of an oxide layer, a nitride layer, or a transparent insulating material. However, the present invention is not limited thereto.

The gate electrode 130 is formed on the gate insulating layer 120 and the gate electrode 130 is formed on a channel region (not shown) of the transparent semiconductor layer 110 in a predetermined pattern. The gate electrode 130 is formed of Indium Tin Oxide (ITO), Indium Zinc Oxide (IZO), or Indium Tin Zinc Oxide (ITZO), which are transparent or semi-transparent metals. However, the present invention is not limited thereto.

The interlayer insulating layer 140 is formed on the gate electrode 130 to insulate the gate electrode 130 from the source and drain electrodes 150a and 150b. The interlayer insulating layer 140 is formed of the same material as the gate insulating layer 120.

The source and drain electrodes 150a and 150b are formed on the interlayer insulating layer 140 to be electrically connected to both sides of the transparent semiconductor layer 110 through contact holes (not shown) formed in the gate insulating layer 120 and the interlayer insulating layer 140. The source and drain electrodes 150a and 150b are formed of metals having a high conductivity and a high transparency, such as ITO, IZO, ITZO, or are formed of semi-transparent metals. However, the present invention is not limited thereto.

FIGs. 2A to 2C are sectional views of processes of a method of manufacturing a TFT according to a first embodiment of the present invention.

First, as illustrated in FIG. 2A, the substrate 100 is coated with a wide band gap semiconductor material whose band gap is no less than 3.0eV to form a transparent semiconductor layer 110 in a predetermined pattern. The transparent semiconductor layer 110 is formed of a transparent material, for example, at least one conductive metal material selected from the group consisting of ZnO, ZnSnO, CdSnO, GaSnO, TlSnO, InGaZnO, CuAlO, SrCuO, and LaCuOS, which are oxides, the group consisting of GaN, InGaN, AlGaN, and InGaAlN, which are nitrides, or the group consisting of SiC and diamond, which are carbides. The transparent semiconductor layer 110 is obtained by applying a transparent material by a Chemical Vapor Deposition (CVD) method to a thickness of about 300Å to 2,000Å and then, patterning the transparent material in a predetermined shape, for example, an island shape. The transparent semiconductor layer 110 is patterned using an etching mask obtained by applying, exposing, and developing a photoresist (PR).

The transparent semiconductor layer 110 is obtained by applying a transparent material to improve its aperture ratio so that it is possible to reduce a basic data value required during designing.

According to the above-described embodiment, the transparent semiconductor layer 110 is formed by the CVD method. However, it also can be formed by a Pulse Laser Deposition (PLD) method, an Atomic Layer Deposition (ALD) method, a sputtering method, or a Molecular Beam Epitaxy (MBE) method.

As illustrated in FIG. 2B, the gate insulating layer 120 is formed on the substrate 100 including the transparent semiconductor layer 110. The gate insulating layer 120 is obtained by applying an oxide layer, a nitride layer, or a transparent insulating material by a Plasma Enhanced Chemical Vapor Deposition (PECVD) method to a thickness of about 700Å to 1,000Å.

The gate electrode 130 is then formed on the gate insulating layer 120. To be specific, after depositing a transparent conductive metal, such as ITO, IZO, ITZO, or a semi-transparent metal, on the gate insulating layer 120 by sputtering to a thickness of about 2,000Å to 3,000Å, the metal is patterned into a predetermined shape.

Then, as illustrated in FIG. 2C, the interlayer insulating layer 140 is formed on the gate insulating layer 120 containing the gate electrode 130. The interlayer insulating layer 140 is formed by the same method as that of the gate insulating layer 120.

Contact holes (not shown) that expose portions of both sides of the transparent semiconductor layer 110 are formed. In order to fill the contact holes, a metal having a high conductivity and a high transparency, such as ITO, IZO, ITZO, or a semi-transparent metal, is deposited to a thickness of about 3,000 Å to 4,000Å. Next, after applying photoresist onto the metal layer, the metal layer is patterned into a predetermined shape to form the source and drain electrodes 150a and 150b.

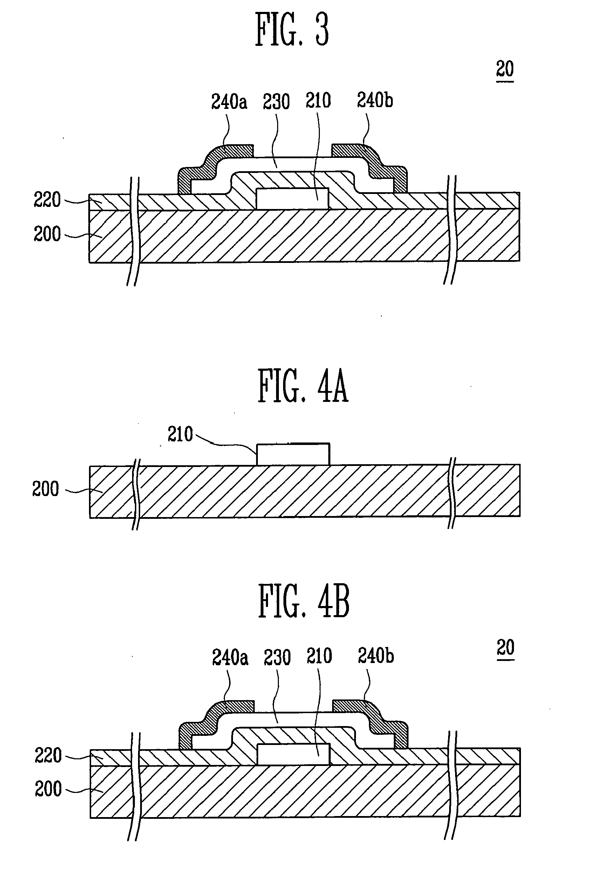

FIG. 3 is a schematic sectional view of a transparent TFT having a bottom gate structure according to a second embodiment of the present invention.

Referring to FIG. 3, a transparent TFT 20 includes the gate electrode 210 formed on the substrate 200, the gate insulating layer 220 formed on the substrate 200 where the gate electrode 210 is formed, a transparent semiconductor layer 230 formed by coating the gate insulating layer 220 with an oxide, a nitride, or a carbide to pattern the applied material, and the source and drain electrodes 240a and 240b formed on the transparent semiconductor layer 230 so that the gate electrode 210 and a region of the transparent semiconductor layer 230 are exposed.

The substrate 200 is formed of an insulating material, such as glass, plastic, silicon, or a synthetic resin, and is preferably a transparent substrate, such as a glass substrate.

The gate electrode 210 is formed on the substrate 200 in a predetermined pattern and is formed of ITO, IZO, or ITZO, which are transparent and semi-transparent metals. However, the present invention is not limited thereto.

The gate insulating layer 220 is formed on the substrate 200 containing the gate electrode 210 to insulate the gate electrode 210 from the transparent semiconductor layer 230. The gate insulating layer 220 is formed of an oxide layer, a nitride layer, or a transparent insulating material. However, the present invention is not limited thereto.

The transparent semiconductor layer 230 is formed on the gate insulating layer 220 in a predetermined pattern. The transparent semiconductor layer 230 is formed of at least one conductive metal material selected from the group consisting of ZnO, ZnSnO, CdSnO, GaSnO, TlSnO, InGaZnO, CuAlO, SrCuO, and LaCuOS, which are wide band gap semiconductor material oxides whose band gap is no less than 3.0eV, the group consisting of GaN, InGaN, AlGaN, and InGaAlN, which are nitrides, or the group consisting of SiC and diamond, which are carbides.

The source and drain electrodes 240a and 240b are formed on the transparent semiconductor layer 230 to expose a region of the transparent semiconductor layer 230.

The source and drain electrodes 240a and 240b are formed of metals having a high conductivity and a high transparency, such as ITO, IZO, ITZO, or a semi-transparent metal. However, the present invention is not limited thereto.

FIGs. 4A and 4B are sectional views of processes of a method of manufacturing a TFT according to a second embodiment of the present invention.

First, as illustrated in FIG. 4A, the gate electrode 210 is formed on the substrate 200. To be specific, after depositing a transparent conductive metal, such as ITO, IZO, ITZO, or a semi-transparent metal, on the gate insulating layer 220 by sputtering, the metal is patterned in a predetermined shape, for example, a tapered shape.

Next, as illustrated in FIG. 4B, the gate insulating layer 220 is formed on the substrate wherein the gate electrode 210 is formed. The gate insulating layer 220 is obtained by depositing an oxide layer, a nitride layer, or a transparent insulating material by the PECVD method.

The gate insulating layer 220 is coated with a wide band gap semiconductor material whose band gap is no less than 3.0eV to form the transparent semiconductor layer 230 in a predetermined pattern. The transparent semiconductor layer 230 is formed of a transparent material, for example, a conductive metal material selected from the group consisting of ZnO, ZnSnO, CdSnO, GaSnO, TlSnO, InGaZnO, CuAlO, SrCuO, and LaCuOS, which are oxides, the group consisting of GaN, InGaN, AlGaN, and InGaAlN, which are nitrides, or the group consisting of SiC and diamond, which are carbides. The transparent semiconductor layer 230 is obtained by applying a transparent material by a Chemical Vapor Deposition (CVD) method to a thickness of about 300Å to 2,000Å and then patterning the transparent material in a predetermined shape, for example, an island shape. The transparent semiconductor layer 230 is patterned using an etching mask obtained by applying, exposing, and developing a photoresist (PR).

The transparent semiconductor layer 230 is obtained by applying a transparent material to improve its aperture ratio so that it is possible to reduce a basic data value required during designing.

According to the above-described embodiment, the transparent semiconductor layer 230 is formed by the CVD method. However, it can be formed by a Pulse Laser Deposition (PLD) method, an Atomic Layer Deposition (ALD) method, a sputtering method, and a Molecular Beam Epitaxy (MBE) method.

A transparent conductive metal, such as ITO, IZO, ITZO, or a semi-transparent metal, is deposited on the transparent semiconductor layer 230 by sputtering to pattern the metal into a predetermined shape so that the source and drain electrodes 240a and 240b are obtained.

According to the above-described embodiments, the top gate (coplanar) structure and the bottom gate (reverse staggered) structure and their methods of manufacture have been described. However, the present invention can be applied to a staggered structure.

As described above, according to the present invention, the semiconductor layer of the TFT is formed of a transparent material, such as an oxide, a nitride, or a carbide, to improve its aperture ratio so that it is possible to relax design rules of a display and to improve the resolution of the display.

Furthermore, in the case of an organic display, when the transparent TFT is used as the switching device of the light emitting display, it is possible to increase the width of a channel so that it is possible to prevent deterioration and to display an image of high resolution. Also, since it is possible to increase the width of the channel, it is possible to reduce power consumption.

Also, in the case of an LCD, since the transparent semiconductor layer is formed so that the light of a back light is not absorbed into the channel layer, it is possible to reduce power consumption without unnecessary loss of light.

Although exemplary embodiments of the present invention have been described for illustrative purposes, those skilled in the art will appreciate that various modifications, additions and substitutions are possible, without departing from the scope of the present invention as recited in the accompanying claims.

## Claims

1. A transparent Thin Film Transistor (TFT), comprising:
a substrate;
a transparent semiconductor layer arranged over the substrate, the transparent semiconductor layer including one of an oxide, a nitride, or a carbide;
a gate electrode arranged over the substrate;
a gate insulating layer arranged between the transparent semiconductor layer and the gate electrode; and
source and drain electrodes electrically connected to the transparent semiconductor layer.

2. A transparent TFT according to claim 1, wherein:
the transparent semiconductor layer is arranged on the substrate in a pattern;
the gate insulating layer is arranged on the transparent semiconductor layer;
the gate electrode is arranged on the gate insulating layer to correspond to the transparent semiconductor layer;
an interlayer insulating layer is arranged on the gate electrode; and
the source and drain electrodes are electrically connected to the transparent semiconductor layer through contact holes arranged in the interlayer insulating layer and the gate insulating layer.

3. A transparent Thin Film Transistor (TFT), according to claim 1, wherein:
the gate electrode is arranged on the substrate;
the gate insulating layer is arranged on the gate electrode and the substrate;
the transparent semiconductor layer is arranged in a pattern on the gate insulating layer; and
the source and drain electrodes are arranged on the transparent semiconductor layer to expose a region of the transparent semiconductor layer.

4. A transparent TFT according to any preceding claim, wherein the transparent semiconductor layer comprises a wide band gap semiconductor material having a band gap greater than 3.0eV.

5. A transparent TFT according to claim 4, wherein the transparent semiconductor layer comprises a semiconductor material selected from a group consisting of ZnO, ZnSnO, CdSnO, GaSnO, TlSnO, InGaZnO, CuAlO, SrCuO, and LaCuOS.

6. A transparent TFT according to claim 4, wherein the transparent semiconductor layer comprises a semiconductor material selected from a group consisting of GaN, InGaN, AlGaN, and InGaAlN.

7. A transparent TFT according to claim 4, wherein the transparent semiconductor layer comprises a semiconductor material selected from a group consisting of SiC and diamond.

8. A transparent TFT according to any preceding claim, wherein the transparent semiconductor layer has a thickness in a range of 300Å to 700Å.

9. A method of manufacturing a transparent TFT, the method comprising:
providing a substrate;
providing a transparent semiconductor layer over the substrate, the transparent semiconductor layer including one of an oxide, nitride or a carbide;
providing a gate electrode over the substrate;
arranging a gate insulating layer between the transparent semiconductor layer and the gate electrode; and
depositing a transparent electrode to form source and drain electrodes.

10. A method of manufacturing a transparent TFT according to claim 9 wherein
providing the transparent layer over the subtrate comprises coating a substrate with an oxide, a nitride, or a carbide to form the transparent semiconductor layer;
providing the gate insulating layer comprises forming the gate insulating layer on the transparent semiconductor layer;
providing the gate electrode comprises forming the gate electrode on the gate insulating layer to correspond to the transparent semiconductor layer;
the method further comprising forming an interlayer insulating layer on the gate electrode; and
forming contact holes that pass through the interlayer insulating layer and the gate insulating layer.

11. A method of manufacturing a transparent TFT, according to claim 9: wherein
providing the gate electrode comprises forming the gate electrode patterned on a substrate;
providing the gate insulating layer comprises forming the gate insulating layer on the gate electrode;
providing the transparent semiconductor layer comprises coating the gate insulating layer with an oxide, a nitride, or a carbide to form the transparent semiconductor layer; and
wherein the source and drain electrodes are formed on the transparent semiconductor layer.

12. A method according to any one of claims 9 to 11, wherein forming the transparent semiconductor layer comprises one of: a Pulse Laser Deposition (PLD) method, an Atomic Layer Deposition (ALD) method, a Chemical Vapor Deposition (CVD) method, a sputtering method, and a Molecular Beam Epitaxy (MBE) method.

13. A flat panel display comprising a TFT according to any one of claims 1 to 8.
